Europäisches Patentamt

European Patent Office

Office européen des brevets

(11) Publication number: **0 113 088**
**B1**

## EUROPEAN PATENT SPECIFICATION

(45) Date of publication of patent specification: **24.05.89**

(51) Int. Cl.⁴: **H 01 L 23/14, H 01 L 23/36**

(21) Application number: **83112658.6**

(22) Date of filing: **15.12.83**

(54) Substrate for mounting semiconductor element.

(30) Priority: **22.12.82 JP 225239/82**
**22.12.82 JP 225240/82**

(43) Date of publication of application:
**11.07.84 Bulletin 84/28**

(45) Publication of the grant of the patent:
**24.05.89 Bulletin 89/21**

(84) Designated Contracting States:
**DE GB NL**

(56) References cited:
**EP-A-0 009 978**
**EP-A-0 100 232**

(73) Proprietor: **SUMITOMO ELECTRIC INDUSTRIES LIMITED**
**No. 15, Kitahama 5-chome Higashi-ku Osaka-shi Osaka 541 (JP)**

(72) Inventor: **Ogasa, Nobuo c/o Itami Works of Sumitomo**
**Electric Industries, Ltd. 1-1, Koyakita 1-chome Itami-shi Hyogo (JP)**
Inventor: **Ohtsuka, Akira c/o Itami Works of Sumitomo**
**Electric Industries, Ltd. 1-1, Koyakita 1-chome Itami-shi Hyogo (JP)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath Maximilianstrasse 58 D-8000 München 22 (DE)**

Courier Press, Leamington Spa, England.

## Description

The invention pertains to a substrate for supporting a semiconductor element comprising a metal base and a coating of an electrically insulating material on said metal base.

Conventionally, low melting point glass ceramic materials have been used to form a substrate upon which an integrated circuit chip or the like is mounted in applications requiring high reliability. Typical materials for this use are $Al_2O_3$, BeO and $2MgO.SiO_2$. The semiconductor element is joined to the ceramic substrate through a metal layer formed by vapour deposition or plating. While the above-mentioned materials are suitable from a point of view of providing an air-tight seal with other package elements and in that they are electrically insulating, there thermal expansion coefficient is different than that of ordinary semiconductor materials.

Moreover, as integrated circuit device densities further increase, resulting in an attendant increase in the amount of heat generated in each element, the demand for an improved thermal conductivity of substrate materials has increased. $Al_2O_3$ and $2MgO.SiO_2$ have poor thermal conductivities, and hence are not suitable for higher-density integrated circuit applications. Although BeO has a good thermal conductivity, its use is disadvantageous in that this material is expensive and difficult to work with because of its extreme toxicity. Furthermore $Al_2O_3$, which has very commonly been employed in prior art constructions, sometimes induces malfunctions in the integrated circuits that it is used to package due to the fact that the material has a residual radioactivity, specifically, it produces alpha rays. Hence, there is a present demand for an improved substrate material which is electrically insulating, thermally conductive, has a thermal coefficient of expansion similar to that of the semiconductor element it supports, and which is strong.

From EP—A—0 009 978, a substrate for supporting a semi-conductor element comprising a metal base and a coating of an electrically insulating material on said metal base is known. The substrate comprises a composite structure of a thermally conductive metal, such as copper, silver or an alloy thereof, and further comprises fibres which are embedded in the thermally conductive metal. The thermal expansion coefficient of the composite structure is chosen to be substantially equal to or lower than that of the material of the insulated layer which covers the composite structure. The thickness of the insulating layer is chosen to be about 200 to 300 μm.

As the material for the insulating layer, $Al_2O_3$ is mentioned, with a thickness of between 200 μm and 300 μm.

The invention intends to suggest an improved substrate material which is electrically insulating, thermally conductive, has a thermal coefficient of expansion similar to that of the semiconductor element it supports and which is strong.

This object is solved by a substrate having the features of claim 1. With these features, the invention provides a substrate composite of a base of W alloy containing Cu in an amount of 5 to 20 wt% and having a thermal expansion coefficient in a range of 4.5 to 7.5 × $10^{-6}$/ degree C and a thermal conductivity of 0.4 cal/cm. sec. degree C or greater. The metal base is covered with a coating composed of an electrically inorganic material having a thickness in a range of 0.1 to 20 μm.

In an alternative embodiment, the metal base may be composed of a Mo alloy containing Cu in an amount of 5 to 30 wt% and having a thermal expansion coefficient of 5.0 to 8.0 to $10^{-6}$ degree C and a thermal conductivity of 0.38 cal/cm. sec. degree C or above.

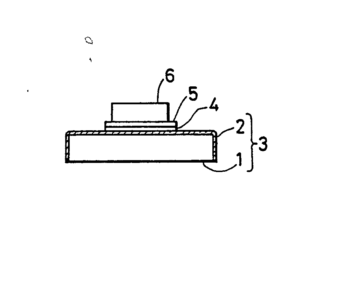

Brief description of the drawing

The single drawing figure shows in cross section a semiconductor device employing a substrate constructed in accordance with the present invention.

Description of the preferred embodiments

Referring now to the single drawing figure, there is shown therein in cross section a semiconductor device in which a semiconductor element is mounted upon a substrate constructed in accordance with the teachings of the present invention. A metal base 1, having a coefficient of thermal expansion approximately equal to that of a semiconductor element 6, is coated with a layer 2 of an inorganic material. The semiconductor element 6 is mounted on the metal base 1 thorugh a metallisation layer 4 and an Au plated layer 5.

In one preferred embodiment, the metal base is formed of a W alloy containing Cu in an amount of 5 to 20 wt% and having a thermal expansion coefficient of 4.5 to 7.5 × $10^{-6}$ degree C and a thermal conductivity of at least 0.4 cal/cm. sec. degree C. The thickness of the coating layer 2 should be in a range of 0.1 to 20 μm.

The thermal expansion coefficient is restricted to the range of 4.5 to 7.5 × $10^{-6}$ in accordance with the invention so as to match the coefficient of thermal expansion of the substrate to those of Si and GaAs, the most commonly employed semiconductor materials at the present time. This range of coefficient of thermal expansion also closely matches the coefficient of thermal expansion of $Al_2O_3$ ceramic material, which is often used in combination with semiconductor materials to reduce the mechanical stress thereon. The thermal conductivity should be at least 0.4 cal/cm. sec. degree C to obtain a sufficiently high thermal conductivity for high-speed integrated circuits, specifically, integrated circuits dissipating a power of 10 watts or more.

In a second preferred embodiment, a metal base is fabricated of Mo alloy containing Cu, and having a coefficient of thermal expansion in a range of 5.0 to 8.0 × $10^{-6}$ degree C, and having a thermal conductivity of at least 0.38 cal/cm. sec. degree C. In this case, the substrate is suitable for use with high-speed integrated circuits which have a power dissipation of 8 watts or more.

In the case of a metal base fabricated of W alloy containing Cu, providing Cu in a range of 5 to 20 wt% will yield the desired range of coefficient of thermal expansion, while in the case of the Mo alloy base containing Cu in a range of 5 to 30 wt% will yield the desired range of coefficent of thermal expansion.

To fabricate the metal base, a power metallurgy process is preferred. The reason for using such a process is because the components of the base have greatly different melting points and specific gravities, and it is difficult to fabricate a base of these materials using in another process.

Furthermore, the Cu should be dispersed uniformly in the W or Mo to prevent variations in thermal and mechanical characteristics, thereby preventing, for instance, buckling upon heating. For a starting material, it is preferred to use a W or Mo powder having a particle size in a range of 0.5 to 10 μm.

It is permitted to add other materials for improving various characteristics and some unavoidable impurities are allowed. However, the amount of such material should be limited to no more than 2 wt% or less.

The inorganic material applied to the surface of the metal base may be BN, $Al_2O_3$, AlN, $Si_3N_4$, $Y_2O_3$, $2MgO.SiO_2$, diamond, etc. These materials may also be used in various combinations, if desired.

To coat the inorganic material on to the metal base, a vapor phase plating process, such as a physical vapor deposition process (PVD), chemical vapor deposition process (CVD), or the like may be used. Furthermore, in order to cause the inorganic coating to be applied uniformly, it is preferred that the metal base be coated with a thin layer of a metal such as Ni.

The reason why the thickness of the coating layer is preferably limited to the range of 0.1 to 20 μm is that it is not possible to obtain a suitable electrical insulating property with a thickness below 0.1 μm, while a thickness above 20 μm makes the coating process lengthy and expensive.

Two examples of semiconductor substrates constructed in accordance with the invention will now be discussed.

### Embodiment 1

A semiconductor substrate having on the surface thereof a thin layer of $Al_2O_3$ on which a GaAs semiconductor element is suitably mounted was produced by a process as follows:

A base formed of a Cu/W alloy containing Cu in an amount of 15 wt% and having a thermal expansion coefficient of $6.5 \times 10^{-6}$ was provided so as to approximate the thermal expansion coefficient of GaAs. To form the coating layer, sintered $Al_2O_3$ was evaporated using electron beam heating. The vaporized material was partly ionized by applying high-frequency (13.6 MHz) energy at a power level of 100 to 200 watts in an oxygen atmosphere at a pressure of $5.3 \times 10^{-2}$ Pa ($4 \times 10^{-4}$ Torr) with the substrate heated to a temperature of 200 degrees C. Using this process, the substrate was coated with $AlO_3$ to a thickness of 2.0 μm.

The resulting substrate had a thermal expansion coefficient very close to that of GaAs and had a good thermal conductivity. Moreover, it was found that the inorganic coating had a dielectric strength above 300 V.

This composite substrate is suitable for mounting semiconductor elements formed of GaAs and Si, and also can be used for mounting optical devices, solar cells or the like formed of materials such as GaAs, InP or the like.

### Embodiment 2

A substrate for mounting a semiconductor element coated with a thin layer of $Al_2O_3$ was produced in accordance with the following procedure:

A CuMo alloy containing 20 wt% Cu and having a thermal expansion coefficient of $7.0 \times 10^{-6}$ was produced so as to approximate the thermal expansion coefficient of GaAs. To form the coating layer, sintered $Al_2O_3$ was evaporated using electron beam heating. The vaporized material was partially ionized by applying high-frequency (13.6 MHz) electromagnetic energy with a power of 100 to 200 watts in an oxygen atmosphere at a pressure of $5.3 \times 10^{-2}$ Pa ($4 \times 10^{-4}$ Torr) with the substrate heated to a temperature of 200 degrees C. The coating of $Al_2O_3$ was formed to a thickness of 2.0 μm.

As a result, a substrate was produced having a thermal expansion coefficient very close to that of GaAs with a high thermal conductivity. The dielectric strength of the coating layer was found to be higher than 300 V. This substrate is suitable for the same uses as those of Embodiment 1 described above.

### Claims

1. A substrate for supporting a semiconductor element comprising a metal base and a coating of an electrically insulating material on said metal base characterized therein that said metal base is made of a material selected from the group consisting of W alloy containing Cu in an amount of 5 to 20 wt% having a thermal expansion coefficient in a range of 4.5 to $7.5 \times 10^{-6}$/degree C, and a thermal conductivity of 0.4 cal/cm. sec. degree C, and Mo alloy containing Cu in an amount of 5 to 30 wt% with a thermal expansion coefficient of 5.0 to $8.0 \times 10^{-6}$/degree C and a thermal conductivity of at least 0.38 cal/cm. sec. degree C, and a coating (2) of an electrically insulating inorganic material on said metal base (1) having a thickness in a range of 0.1 to 20 μm.

2. The substrate of claim 1, wherein the metal base (1) is produced by a powder sintering process.

3. The substrate of claim 2, wherein, in said metal base (1) Cu exists uniformly with W or Mo.

4. The substrate of claim 1, wherein said coating layer (2) is selected from the group consisting

of BN, Al$_2$O$_3$, Si$_3$N$_4$, Y$_2$O$_3$, 2MgO.SiO$_2$, diamond, and laminated combinations thereof.

## Patentansprüche

1. Trägersubstrat für ein Halbleiterelement, mit einer Metallbasis und einem Überzug aus elektrisch isolierendem Material auf dieser Metallbasis, dadurch gekennzeichnet, das die Metallbasis aus einem Material ist, das aus einer Gruppe ausgewählt ist, die aus einer Wolframlegierung besteht, die Kupfer in einem Anteil von 5 bis 20 Gewichtsprozent umfaßt und einen Wärmeausdehnungskoeffizieten im Bereich von 4,5 bis 7,5 × 10$^{-6}$/°C und Wärmeleitfähigkeit von 0,4 cal/cm.sec.°C aufweist sowie aus einer Molybdänlegierung besteht, die Kupfer in einem Anteil von 5—30 Gewichtsprozent mit einem Wärmeausdehungskoeffizienten von 5,0—8,0 × 10$^{-6}$/°C und eine Wärmeleitfähigkeit von wenigstens 0,38 cal/cm.sec.°C aufweist und wobei der Überzug (2) auf der Metallbais (1) aus einem elektrisch isolierenden, anorganischen Material besteht und eine Dicke in einem Bereich von 0,1 bis 20 μm aufweist.

2. Trägersubstrat nach Anspruch 1, woebei die Metallbasis (1) durch ein Pulversinterverfahren hergestellt wird.

3. Trägersubstrat nach Anspruch 2, wobei in der Metallbasis (1) Kupfer gleichmäßig mit Wolfram oder Molybdän vorliegt.

4. Trägerschicht nach Anspruch 1, wobei die Überzugsschicht (2) aus einer Gruppe ausgewählt ist, die aus BN, AL$_2$O$_3$, Si$_3$N$_4$, Y$_2$O$_3$, 2MgO. SiO$_2$, Diamant- und laminierten Kombinationen daraus besteht.

## Revendications

1. Substrat destiné à porter un élément semiconducteur, qui comprend une base métallique et un revêtement d'un matériau électriquement isolant déposé sur ladite base métallique, caractérisé en ce que ladite base métallique est faite d'un matériau choisi dans le groupe formé d'un alliage de tungstène (W) contenant du cuivre (Cu) en une quantité de 5 à 20% en poids et présentant un coefficient de dilatation thermique compris dans l'intervalle de 4,5 à 7,5 × 10$^{-6}$ (°C)$^{-1}$ et une conductivité thermique de 0,4 cal. (cm.s.°C)$^{-1}$ et d'un alliage de molybdène (Mo) contenant du cuivre (Cu) en une quantité de 5 à 30% en poids et présentant un coefficient de dilatation thermique de 5,0 à 8,0 × 10$^{-6}$ (°C)$^{-1}$ et une conductivité thermique d'au moins 0,38 cal. (cm.s.°C)$^{-1}$, et en ce qu'une revêtement (2) d'un matériau non organique électriquement isolant déposé sur ladite base métallique (1) possède une épaisseur comprise entre 0,1 et 20 μm.

2. Substrat selon la revendication 1, où la base métallique (1) est produit par un processus de frittage de poudre.

3. Substrat selon la revendication 2, où, dans ladite base métallique (1), Cu existe uniformément avec W ou Mo.

4. Substrat selon la revendication 1, où ladite couche de revêtement (2) est choisie dans le groupe formé de BN, Al$_2$O$_3$, Si$_3$N$_4$, Y$_2$O$_3$, 2MgO.SiO$_2$, le diamant, et leurs combinaisons stratifiées.